# EUROPEAN PATENT APPLICATION

(11) **EP 4 369 858 A1**
(43) Date of publication of application: **15.05.2024**
(21) Application number: 22837293.4
(22) Date of filing: 29.03.2022
(51) Int. Cl.: H05B 3/00

(54) **ABNORMALITY DETERMINATION DEVICE, ABNORMALITY DETERMINATION METHOD, AND ABNORMALITY DETERMINATION SYSTEM**

(30) Priority: 09.07.2021 JP 2021114417
(71) Applicant: OMRON CORPORATION, Kyoto-shi, Kyoto 600-8530 (JP)
(72) Inventor: TAKATANI, Ryohei, Kyoto-shi, Kyoto 600-8530 (JP); YAMAGUCHI, Shohei, Kyoto-shi, Kyoto 600-8530 (JP); YAMADA, Takaaki, Kyoto-shi, Kyoto 600-8530 (JP)
(74) Representative: HGF
(86) International application number: PCT/JP2022/015632
(87) International publication number: WO 2023/281872

(57) **Abstract**

An abnormality determination device includes an acquisition unit configured to acquire a resistance value and a power value of an electric heating element of a heater calculated from a voltage across the electric heating element and a current flowing through the electric heating element, a first determination unit configured to perform an abnormality determination that is a determination of whether the heater is abnormal based on the acquired resistance value, and a second determination unit configured to determine whether the acquired power value is in a power settling state where the acquired power value is within a width with respect to a first target value. The first determination unit performs the abnormality determination based on the acquired resistance value when the second determination unit determines that the power settling state is established over a first period.

## Description

### BACKGROUND

### TECHNICAL FIELD

The present disclosure relates to an abnormality determination device, an abnormality determination method, and an abnormality determination system that determine an abnormality of a heater.

### BACKGROUND ART

Patent Document 1 discloses an electric heater that determines an abnormality of a heater based on a magnitude of a change in an electric resistance increase rate during energization.

### CITATION LIST

### PATENT LITERATURE

Patent Document 1: JP H8-124653 A

### SUMMARY

### PROBLEMS TO BE SOLVED BY THE INVENTION

The electric resistance of the heater wire of the electric heater has temperature characteristics. Since the electric heater of Patent Document 1 does not include a sensor for detecting a temperature of the heater wire, it may not be possible to accurately determine the magnitude of the change in the electric resistance increase rate during energization.

An object of the present disclosure is to provide an abnormality determination device, an abnormality determination method, and an abnormality determination system capable of more accurately determining an abnormality of a heater without using temperature information on the heater.

### SOLUTIONS TO THE PROBLEMS

An abnormality determination device according to an aspect of the present disclosure includes:
an acquisition unit configured to acquire a resistance value and a power value of an electric heating element of a heater calculated from a voltage across the electric heating element and a current flowing through the electric heating element;
a first determination unit configured to perform an abnormality determination that is a determination of whether the heater is abnormal based on the acquired resistance value; and
a second determination unit configured to determine whether the acquired power value is in a power settling state within a width with respect to a first target value,
wherein the first determination unit performs the abnormality determination based on the acquired resistance value when the second determination unit determines that the power settling state is established over a first period.

An abnormality determination method according to an aspect of the present disclosure includes:
acquiring a resistance value and a power value of an electric heating element of a heater calculated from a voltage across the electric heating element and a current flowing through the electric heating element;
determining whether the acquired power value is in a power settling state within a width with respect to a first target value; and
performing an abnormality determination that is a determination of whether the heater is abnormal based on the acquired resistance value when it is determined that the power settling state is established over a first period.

An abnormality determination system according to an aspect of the present disclosure includes:
a first device; and a second device, wherein
the first device includes:
   a first acquisition unit configured to acquire a resistance value and a power value of an electric heating element of a heater calculated from a voltage across the electric heating element and a current flowing through the electric heating element, and
   a first determination unit configured to perform an abnormality determination that is a determination of whether the heater is abnormal based on the acquired resistance value; and
the second device includes:
   a second acquisition unit configured to acquire the resistance value and the power value of the electric heating element 10, and
   a second determination unit configured to determine whether the acquired power value is in a power settling state within a width with respect to a first target value,
the second device communicatively connected to the first device,
the first acquisition unit acquires a determination result of the second determination unit, and
the first determination unit performs the abnormality determination based on the acquired resistance value when the second determination unit determines that the power settling state is established over a first period.

### EFFECTS OF THE INVENTION

According to the abnormality determination device of the above aspect, it is possible to implement an abnormality determination device capable of more accurately determining an abnormality of a heater without using temperature information of the heater.

According to the abnormality determination method of the above aspect, it is possible to more accurately determine an abnormality of a heater without using temperature information of the heater.

According to the abnormality determination system of the above aspect, it is possible to implement an abnormality determination system capable of more accurately determining an abnormality of a heater without using temperature information of the heater while corresponding to various embodiments.

### BRIEF DESCRIPTION OF THE DRAWINGS

Fig. 1 is a block diagram showing an abnormality determination device according to an embodiment of the present disclosure.
Fig. 2 is a diagram for illustrating a power settling state of the abnormality determination device in Fig. 1.
Fig. 3 is a diagram for illustrating a resistance settling state of the abnormality determination device in Fig. 1.
Fig. 4 is a diagram for illustrating first target value setting processing of the abnormality determination device in Fig. 1.
Fig. 5 is a diagram for illustrating second target value setting processing of the abnormality determination device in Fig. 1.
Fig. 6 is a flowchart for illustrating abnormality determination processing of the abnormality determination device in Fig. 1.
Fig. 7 is a flowchart for illustrating target value setting processing of the abnormality determination device in Fig. 1.
Fig. 8 is a flowchart for illustrating a threshold setting method of the abnormality determination device in Fig. 1.
Fig. 9 is a first graph for illustrating the threshold setting method of the abnormality determination device in Fig. 1.
Fig. 10 is a second graph for illustrating the threshold setting method of the abnormality determination device in Fig. 1.
Fig. 11 is a third graph for illustrating the threshold setting method of the abnormality determination device in Fig. 1.
Fig. 12 is a fourth graph for illustrating the threshold setting method of the abnormality determination device in Fig. 1.

### DETAILED DESCRIPTION

Hereinafter, an example of the present disclosure will be described with reference to the accompanying drawings. It should be noted that in the following description, terms indicating specific directions or positions (for example, terms including "upper", "lower", "right", and "left") are used as necessary, but using these terms is to facilitate understanding of the present disclosure with reference to the drawings, and the technical scope of the present disclosure is not limited by the meaning of the terms. In addition, the following description is, essentially, merely illustrative and is not intended to limit the present disclosure, applied products thereof, or applications thereof. Furthermore, the drawings are schematic, and ratios and the like of the respective dimensions do not necessarily match those of actual ones.

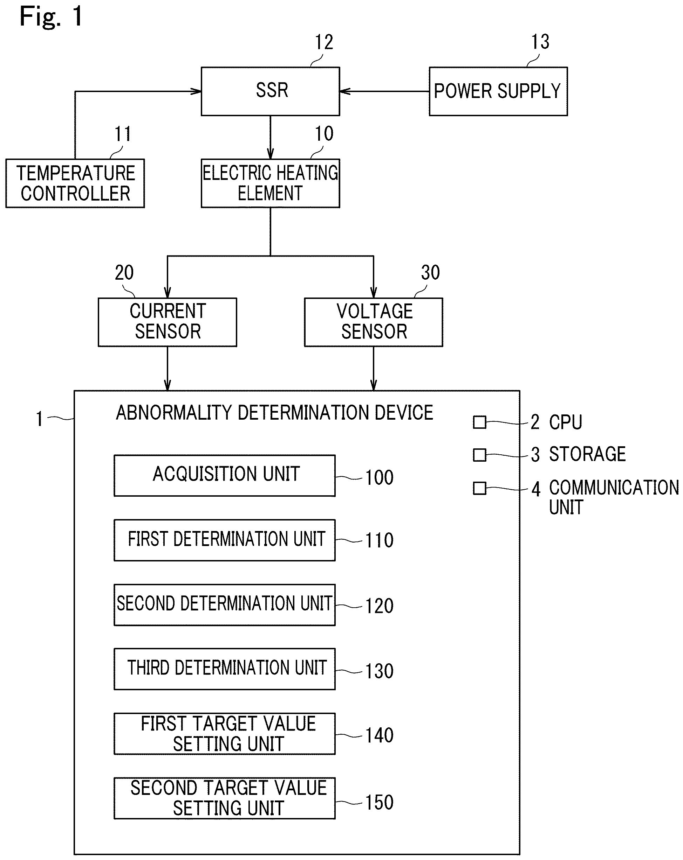

As an example, as shown in Fig. 1, an abnormality determination device 1 according to an embodiment of the present disclosure includes a CPU 2 that performs calculation, a storage 3, and a communication unit 4. The abnormality determination device 1 is configured to perform an abnormality determination of an electric heating element 10 of a heater. The storage 3 is configured to store information such as programs and data necessary for the abnormality determination of the electric heating element 10. The communication unit 4 is configured to input and outputs information to and from an external device (not shown) connected in a wireless or wired manner. The electric heating element 10 is, for example, an electric heating wire of an electric resistance heater. A temperature controller 11 and an SSR (solid state relay) 12 are connected to the electric heating element 10, and a power supply 13 is connected to the solid state relay 12. The temperature controller 11 is configured to control on/off of the solid state relay 12. When the solid state relay 12 is on, a current from the power supply 13 is supplied to the electric heating element 10.

The abnormality determination device 1 includes an acquisition unit 100, a first determination unit 110, and a second determination unit 120. In the present embodiment, the abnormality determination device 1 includes a third determination unit 130, a first target value setting unit 140, and a second target value setting unit 150. Each of the acquisition unit 100, the first determination unit 110, the second determination unit 120, the third determination unit 130, the first target value setting unit 140, and the second target value setting unit 150 is, for example, a function implemented by the CPU 2 executing a predetermined program.

The acquisition unit 100 is configured to acquire a power value and a resistance value of the electric heating element 10 calculated from a voltage across the electric heating element 10 of the heater and a current flowing through the electric heating element 10 through the communication unit 4, for example. The power value and the resistance value of the electric heating element 10 are calculated by the CPU 2 or an external device (not shown) from a current value detected by a current sensor 20 and the voltage value detected by a voltage sensor 30, for example.

In the present embodiment, low-pass filter processing (for example, moving average processing) is applied to the acquired power value and resistance value of the electric heating element 10. The low-pass filter processing on the power value and the resistance value of the electric heating element 10 is performed by the abnormality determination device 1 or an external device, for example. The number of times of moving average processing applied to the power value (hereinafter, referred to as a moving average number of times of the power value) and the number of times of moving average processing applied to the resistance value (hereinafter, referred to as a moving average number of times of the resistance value) are set according to a type of heater or the like. The moving average number of times of the power value and the moving average number of times of the resistance value may be the same or different.

The first determination unit 110 is configured to perform the abnormality determination that is the determination of whether the heater is abnormal based on the resistance value acquired by the acquisition unit 100. The abnormality determination is performed based on whether the acquired resistance value exceeds a preset threshold, for example. When the acquired resistance value exceeds the preset threshold, the first determination unit 110 determines that the heater is abnormal. With such a configuration, an abnormality of the heater can be determined more accurately.

When it is determined that the heater is abnormal, for example, it is notified that deterioration of the heater or failure of the heater is suspected. At this time, a plurality of thresholds may be provided, and an abnormality of the heater may be notified in stages. For example, a value of 103% of a resistance reference value (= a second target value to be described below) is defined as a first threshold, and a value of 105% of the resistance reference value is defined as a second threshold. When the acquired resistance value exceeds the first threshold, it is notified that the deterioration state of the heater is the "caution" level. When the acquired resistance value exceeds the second threshold, it is notified that the deterioration state of the heater is the "alarm" level.

The first determination unit 110 performs the abnormality determination when the second determination unit 120 determines that the power settling state is established over a predetermined period and the third determination unit 130 determines that the resistance settling state is established over a predetermined period. In the present embodiment, the first determination unit 110 determines that the heater is in the settling state and performs the abnormality determination when it is determined that the power settling state is established over a period (an example of a first period) obtained by multiplying a cycle in which a power value is acquired by the moving average number of times of the power value and it is determined that the resistance settling state is established over a period (an example of a third period) obtained by multiplying a cycle in which the resistance value is acquired by the moving average number of times of the resistance value (in other words, when the settling condition is satisfied).

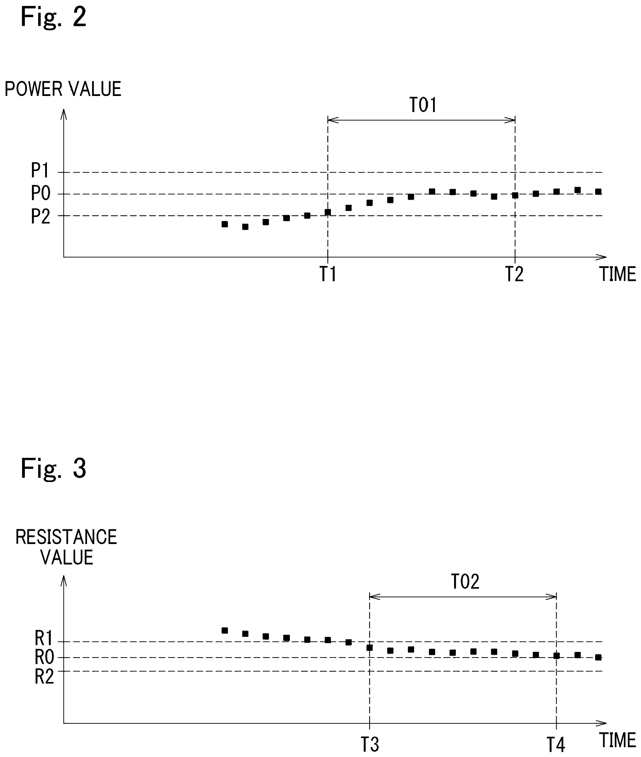

Fig. 2 shows an example in which a determination result all of the second determination unit 120 is in the power settling state over the predetermined period. Fig. 3 shows an example in which a determination result all of the third determination unit 130 is in the resistance settling state over the predetermined period. In Figs. 2 and 3, each of the moving average number of times of the power value and the moving average number of times of the resistance value is set to 10 times. In Fig. 2, the first target value that is the power reference value is indicated by P0, an upper limit value of a width with respect to the first target value is indicated by P1, and a lower limit value of the width with respect to the first target value is indicated by P2. In Fig. 3, the second target value that is the resistance reference value is indicated by R0, an upper limit value of a width with respect to the second target value is indicated by R1, and a lower limit value of the width with respect to the second target value is indicated by R2.

In Fig. 2, the power value all acquired over a period T01 between time T1 and time T2 is positioned within the width with respect to the first target value P0. The period T01 is a period obtained by multiplying the cycle in which the power value is acquired by the moving average number of times of the power value. In Fig. 3, the resistance value all acquired over a period T02 between time T3 and the time T4 is positioned within the width with respect to the second target value R0. The period T02 is a period obtained by multiplying the cycle in which the resistance value is acquired by the moving average number of times of the resistance value. The first determination unit 110 performs the abnormality determination based on the resistance value acquired at or after time T4, but when any one of the following conditions is satisfied, the first determination unit 110 does not perform the abnormality determination and acquires again determination results by the second determination unit 120 and the third determination unit 130.
- The case where a determination result acquired by the second determination unit 120 in the period T01 includes a determination that the power settling state is not established, or the case where a determination result acquired by the third determination unit 130 in the period T02 includes a determination that the resistance settling state is not established.
- The case where a determination result acquired by the second determination unit 120 is the determination that the power settling state is not established, or the case where a determination result acquired by the third determination unit 130 is the determination that the resistance settling state is not established.

The second determination unit 120 is configured to determine whether or not the acquired power value is in the power settling state where the acquired power value is within a width with respect to the first target value. In the present embodiment, the first target value is set by the first target value setting unit 140. The width with respect to the first target value is set to plus or minus 20% of the first target value, for example. The upper limit value and the lower limit value of the width with respect to the first target value may or may not be included in "within the width with respect to the first target value".

The third determination unit 130 is configured to determine whether or not the acquired resistance value is in the resistance settling state where the acquired resistance value is within the width with respect to the second target value. In the present embodiment, the second target value is set by the second target value setting unit 150. The width with respect to the second target value is set to plus or minus 1% of the second target value, for example. The upper limit value and the lower limit value of the width with respect to the second target value may or may not be included in "within the width with respect to the second target value".

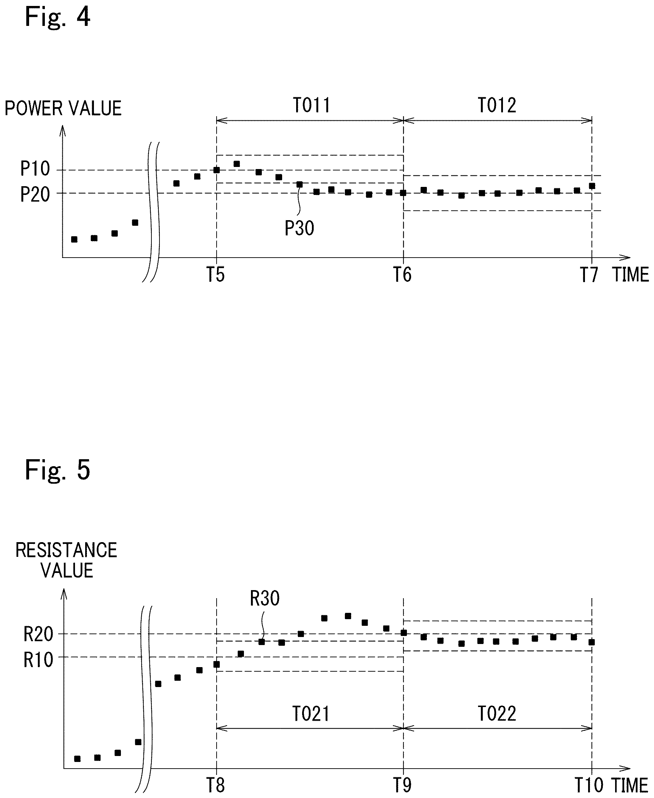

The first target value setting unit 140 is configured to set the power value when setting of the first target value is started as a temporary first target value, and is configured to set the temporary first target value as the first target value when it is determined that the power value all acquired within a predetermined period is within a width with respect to the temporary first target value. For example, as shown in Fig. 4, when setting of the first target value is started from time T5, the first target value setting unit 140 sets a power value P 10 acquired at the time T5 as the temporary first target value. In the present embodiment, when it is determined that the power value all acquired within the period (an example of the second period) obtained by multiplying the cycle in which the power value is acquired by the moving average number of times of the power value is within the width with respect to the temporary first target value (in other words, when a setting condition of the first target value is satisfied), the temporary first target value is set as the first target value. The width with respect to the temporary first target value is set to plus or minus 20% of the temporary first target value, similarly to the first target value, for example.

For example, the setting of the first target value is started at any timing after a predetermined time is elapsed since the abnormality determination device 1 received a setting start command issued when current is supplied from the power supply 13 to the electric heating element 10. For example, the later one of time until the power value is acquired the moving average number of times of the power value and time until the resistance value is acquired the moving average number of times of the resistance value is set as the predetermined time.

When it is determined that the power value all acquired within the predetermined period is not within the width with respect to the temporary first target value, the first target value setting unit 140 resets the power value acquired last as the temporary first target value.

For example, as shown in Fig. 4, it is assumed that the setting of the first target value is started from the time T5, but the power value all acquired within the initial period T011 is not within the width with respect to the set temporary first target value. In this case, the first target value setting unit 140 resets a power value P20 acquired last in the initial period T011 as the temporary first target value. In Fig. 4, since the power value all acquired in the next period T02 is within a width with respect to the power value P20 which is the reset temporary first target value, the first target value setting unit 140 sets the power value P20 as the first target value. In general, it is considered that the power value acquired last in the first period is a power value acquired closer to the power settling state than the power value acquired when it is determined that the power value is not within the width with respect to the first target value. Therefore, by resetting the power value acquired last in the first period as the temporary first target value, the setting processing of the first target value can be shortened.

The number of times that the first target value setting unit 140 resets the temporary first target value (in other words, the number of times of determining whether or not the setting condition of the first target value is satisfied) may set an upper limit. For example, when the first target value has not been continuously set a predetermined number of times (for example, five times), the first target value setting unit 140 does not reset the temporary first target value and does not set the first target value.

The second target value setting unit 150 sets as the temporary second target value the resistance value when setting of the second target value is started, and sets the temporary second target value as the second target value when it is determined that the resistance value all acquired within the predetermined period is within a width with respect to the temporary second target value. For example, as shown in Fig. 5, when the setting of the second target value is started from time T8, the second target value setting unit 150 sets a resistance value R10 acquired at the time T8 as the temporary second target value. In the present embodiment, when it is determined that the resistance value all acquired within the period (an example of the fourth period) obtained by multiplying the cycle in which the resistance value is acquired by the moving average number of times of the resistance value is within the width with respect to the temporary second target value (in other words, when a setting condition of the second target value is satisfied), the temporary second target value is set as the second target value. The width with respect to the temporary second target value is set to plus or minus 1% of the temporary second target value, similarly to the second target value, for example.

The setting of the second target value is started at any timing after a predetermined time is elapsed since the abnormality determination device 1 received a setting start command issued when current is supplied from the power supply 13 to the electric heating element 10, for example. The setting of the second target value may or may not be started at the same time as the setting of the first target value. For example, the later one of the time until the power value is acquired the moving average number of times of the power value and the time until the resistance value is acquired the moving average number of times of the resistance value is set as the predetermined time.

When it is not determined that the resistance value all acquired within the predetermined period is within the width with respect to the temporary second target value, the second target value setting unit 150 resets the most recently acquired resistance value as the temporary second target value.

For example, as shown in Fig. 5, it is assumed that the setting of the second target value is started from the time T8, but the resistance value all acquired in an initial period T021 is not within the width with respect to the set temporary second target value. In this case, the second target value setting unit 150 resets a resistance value R20 acquired last in the initial period T021 as the temporary second target value. In Fig. 5, since the resistance value all acquired within a next second period T022 is within a width with respect to the resistance value R20 which is the reset temporary second target value, the second target value setting unit 150 sets the resistance value R20 as the second target value. Since the resistance value acquired last is an average of the resistance value acquired during the second period, the setting processing of the second target value can be shortened by resetting the resistance value acquired last within the second period as the temporary second target value.

The number of times that the second target value setting unit 150 resets the temporary second target value (in other words, the number of times of determining whether or not a setting condition of the second target value is satisfied) may set an upper limit. For example, when the second target value has not been continuously set a predetermined number of times (for example, five times), the second target value setting unit 150 does not reset the temporary second target value and stops the setting of the second target value.

When the acquired power value is in the power settling state and the acquired resistance value is in the resistance settling state, the second target value setting unit 150 resets the second target value based on an average of the resistance values acquired most recent multiple times (for example, the moving average number of times). The second target value is reset every time the resistance value is acquired a predetermined number of times (for example, the moving average number of times of the resistance value), for example.

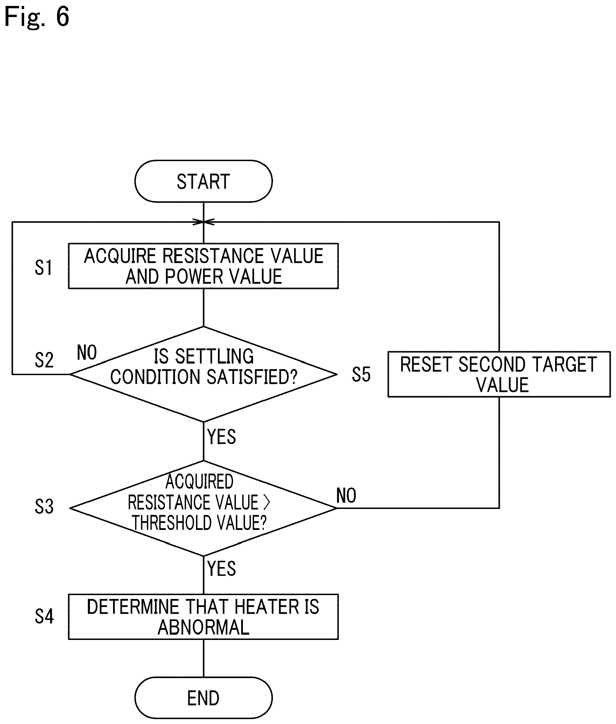

With reference to Fig. 6, abnormality determination processing (an example of an abnormality determination method of the present disclosure) of the abnormality determination device 1 will be described. Here, as an example, a case will be described in which the settling condition is satisfied when it is determined that the power settling state is established over the first period and it is determined that the resistance settling state is established over the third period, and the second target value is reset every time the resistance value is acquired once. The processing described below is implemented by the CPU executing a predetermined program.

As shown in Fig. 6, the acquisition unit 100 acquires the resistance value and the power value of the electric heating element 10 (step S1), and the first determination unit 110 determines whether or not the settling condition is satisfied, in other words, whether or not it is determined that the power settling state is established over the first period and it is determined that the resistance settling state is established over the third period (step S2). When it is not determined that the settling condition is satisfied, the first determination unit 110 does not perform the abnormality determination. Thereafter, the process returns to step S1, and the resistance value and the power value of the electric heating element 10 are acquired.

When it is determined that the settling condition is satisfied, the first determination unit 110 performs the abnormality determination based on whether or not the acquired resistance value is larger than a threshold (step S3). When it is determined that the acquired resistance value is larger than the threshold, the first determination unit 110 determines that the heater is abnormal (step S4), and the abnormality determination processing ends.

When it is determined that the acquired resistance value is equal to or less than the threshold, the second target value setting unit 150 resets the second target value (step S5). Thereafter, the process returns to step S1, and the resistance value and the power value of the electric heating element 10 are acquired.

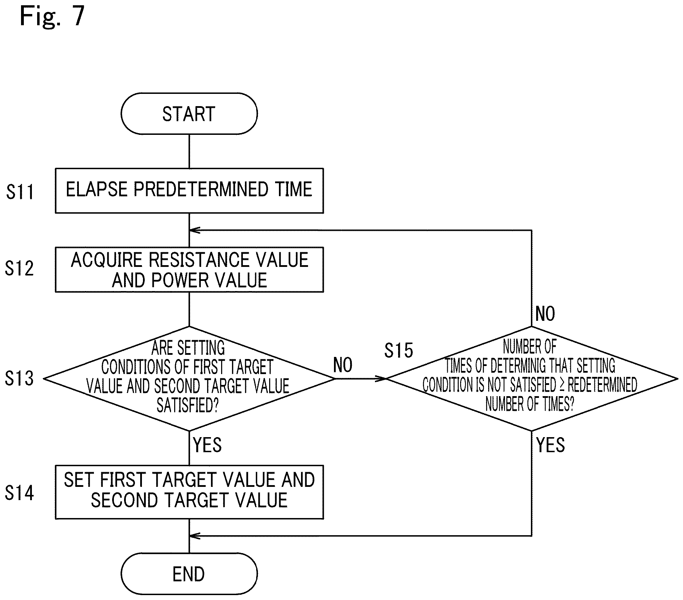

With reference to Fig. 7, target value setting processing of the abnormality determination device 1 will be described. Here, as an example, a case will be described in which "the first target value and the second target value" are set and an upper limit is set to the number of times determining whether or not the setting condition of each target value is satisfied. The processing described below is implemented by the CPU executing a predetermined program.

As shown in Fig. 7, a predetermined time is elapsed from a start of the target value setting (step S11), the acquisition unit 100 acquires the resistance value and the power value of the electric heating element 10 (step S12), the first target value setting unit 140 determines whether or not the setting condition of the first target value is satisfied, and the second target value setting unit 150 determines whether or not the setting condition of the second target value is satisfied (step S13).

When it is determined that the setting conditions of the first target value and the second target value are satisfied, the first target value setting unit 140 sets the first target value, the second target value setting unit 150 sets the second target value (step S14), and the target value setting processing ends.

When it is determined that the setting conditions of the first target value and the second target value is not satisfied, each of the first target value setting unit 140 and the second target value setting unit 150 determines whether the number of times of determining that the setting condition is not satisfied is equal to or more than a predetermined number of times (for example, five times) (step S15). When it is determined that the number of times of determining that the setting condition is not satisfied is equal to or more than the predetermined number of times, each of the first target value setting unit 140 and the second target value setting unit 150 does not set the first target value and the second target value, and the target value setting processing ends. When it is determined that the number of times of determining that the setting condition is not satisfied is less than the predetermined number of times, the process returns to step S12, and the resistance value and the power value of the electric heating element 10 are acquired.

The abnormality determination device 1 can exert the following effects.

The abnormality determination device 1 includes: the acquisition unit 100 configured to acquire the resistance value and the power value of the electric heating element 10, the first determination unit 110 configured to perform the abnormality determination that is the determination of whether or not the heater is abnormal based on the acquired resistance value, and a second determination unit 120 configured to determine whether or not the acquired power value is in the power settling state where the acquired power value is within the width with respect to the first target value. The first determination unit 110 performs the abnormality determination based on the acquired resistance value when the second determination unit 120 determines that the power settling state is established over the first period. With such a configuration, it is possible to implement the abnormality determination device 1 capable of more accurately determining an abnormality of the heater without using temperature information of the heater.

The abnormality determination device 1 may optionally adopt any one configuration or plural configurations out of a plurality of configurations shown next. That is, any one configuration or plural configurations out of a plurality of configurations shown next may be optionally deleted when included in the embodiment, and may be optionally added when not included in the embodiment. By adopting such a configuration, it is possible to more reliably implement an abnormality determination device 1 capable of more accurately determining an abnormality of the heater without using temperature information of the heater.

The low-pass filter processing is applied to the power value. With such a configuration, the power value can be easily settled.

The low-pass filter processing applied to the power value is moving average. With such a configuration, the power value can be easily settled.

The first period is the period obtained by multiplying the cycle in which the power value is acquired by the moving average number of times of the power value. With such a configuration, it is possible to more accurately determine whether or not the heater is in the power settling state.

The abnormality determination device 1 includes the first target value setting unit 140 configured to set the first target value. The first target value setting unit 140 sets as the temporary first target value the power value when the setting of the first target value is started, and sets the temporary first target value as the first target value when it is determined that the power value all acquired within the second period is within the width with respect to the temporary first target value. With such a configuration, the first target value can be set more accurately.

The first target value setting unit 140 resets the power value acquired last as the temporary first target value when it is determined that the power value all acquired within the second period is not within the width with respect to the temporary first target value. With such a configuration, the first target value can be set more accurately.

The power value is subjected to moving average, and the second period is the period obtained by multiplying the cycle in which the power value is acquired by the moving average number of times of the power value. With such a configuration, the power value can be easily settled.

The abnormality determination device 1 includes the third determination unit 130 configured to determine whether or not the acquired resistance value is in the resistance settling state where the acquired resistance value is within the width with respect to the second target value. The first determination unit 110 performs the abnormality determination when the second determination unit 120 determines that the power settling state is established over the first period and the third determination unit 130 determines that the resistance settling state is established over the third period. With such a configuration, it is possible to more accurately determine whether or not the heater is in the settling state.

The low-pass filter processing is applied to the resistance value. With such a configuration, the resistance value can be easily settled.

The low-pass filter processing applied to the resistance value is moving average. With such a configuration, the resistance value can be easily settled.

The third period is the period obtained by multiplying the cycle in which the resistance value is acquired by the moving average number of times of the resistance value. With such a configuration, it is possible to more accurately determine whether or not the heater is in the resistance settling state.

The abnormality determination device 1 includes the second target value setting unit 150 configured to set the second target value. The second target value setting unit 150 sets as the temporary second target value the resistance value when the setting of the second target value is started, and sets the temporary second target value as the second target value when it is determined that the resistance value all acquired within the fourth period is within the width with respect to the temporary second target value. With such a configuration, the second target value can be set more accurately.

The second target value setting unit 150 resets the resistance value acquired last as the temporary second target value when it is determined that the resistance value all acquired within the fourth period is not within the width with respect to the temporary second target value. With such a configuration, the second target value can be set more accurately.

The second target value setting unit 150 resets the second target value based on an average of the resistance values acquired the most recent multiple times when the acquired power value is in the power settling state and the acquired resistance value is in the resistance settling state. With such a configuration, it is possible to set a more accurate second target value according to the temporal change of the heater.

The resistance value is subjected to moving average, and the fourth period is the period obtained by multiplying the cycle in which the resistance value is acquired by the moving average number of times of the resistance value. With such a configuration, it is possible to more accurately determine whether or not the heater is in the resistance settling state while easily settling the resistance value.

According to the abnormality determination method of the present disclosure, the following effects can be exerted.

In the abnormality determination method, the resistance value and the power value of the electric heating element 10 calculated from the voltage across the electric heating element 10 of the heater and the current flowing through the electric heating element 10 are acquired. Whether or not the acquired power value is in the power settling state within the width with respect to the first target value is determined. When it is determined that the power settling state is established over the first period, the abnormality determination that is the determination of whether the heater is abnormal is performed based on the acquired resistance value. With such a configuration, it is possible to more accurately determine the abnormality of the heater without using temperature information of the heater.

The abnormality determination device 1 may also be configured as follows.

The first determination unit 110 may be configured to determine that the heater is in the settling state and perform the abnormality determination when all of the following four conditions are satisfied.
- The power value all acquired within the first period is within the width with respect to the first target value (In other words, the heater is in the power settling state over the first period.).
- The resistance value all acquired within the third period is within the width with respect to the second target value (In other words, the heater is in the resistance settling state over the third period.).
- The acquired voltage value is greater than or equal to a threshold.
- The acquired current value is greater than or equal to a threshold.

For example, when an operation command of the abnormality determination device 1 is issued in a state where the heater is not in operation, or when the heater is stopped after an operation command of the abnormality determination device 1 is issued, a condition that "the acquired voltage value is equal to or greater than the threshold" is satisfied, and the abnormality determination is not performed.

The first determination unit 110 may stop the abnormality determination and acquire a determination result by the second determination unit 120 and the third determination unit 130 again when acquiring the determination that the power settling state is not established or the determination that the resistance settling state is not established.

The third determination unit 130 may be omitted. In this case, when the second determination unit 120 determines that the power settling state is established over the first period, the first determination unit 110 determines that the heater is in the settling state and performs the abnormality determination.

The first target value setting unit 140 and the second target value setting unit 150 may be omitted. In this case, the first target value and the second target value are preset by a user, for example.

The first target value setting unit 140 may be configured to set the temporary first target value as the first target value when all of the following four conditions are satisfied.
- The power value all acquired within the second period is within the width with respect to the temporary first target value (In other words, the heater is in the power settling state over the second period.).
- The resistance value all acquired within the fourth period is within the width with respect to the temporary second target value (In other words, the heater is in the resistance settling state over the fourth period).
- The acquired voltage value is greater than or equal to a threshold.
- The acquired current value is greater than or equal to a threshold.

The second target value setting unit 150 may be configured to set the temporary second target value as the second target value when all of the following four conditions are satisfied.
- The power value all acquired within the second period is within the width with respect to the temporary first target value.
- The resistance value all acquired within the fourth period is within the width with respect to the temporary second target value.
- The acquired voltage value is greater than or equal to a threshold.
- The acquired current value is greater than or equal to a threshold.

For example, when an operation command of the abnormality determination device 1 is issued in a state where the heater is not in operation, or when the heater is stopped after an operation command of the abnormality determination device 1 is issued, setting of each target value is stopped under a condition that "the acquired voltage value is equal to or greater than the threshold". Since a voltage may temporarily decrease due to overshoot or the like, even when the acquired voltage value falls below a threshold, setting of each target value is not immediately stopped and is continuously performed except for when all of the four conditions are not satisfied a predetermined number of times continuously.

The first target value setting unit 140 may be configured to reset a power value when it is first determined that the acquired power value is not within the width with respect to the temporary first target value (for example, indicated as P30 in Fig. 4) as the temporary first target value.

The second target value setting unit 150 may be configured to reset a resistance value when it is first determined that the acquired resistance value is not within the width with respect to the temporary second target value (for example, indicated as R30 in Fig. 5) as the temporary second target value.

The first period, the second period, the third period, and the fourth period may be periods having the same length, or may be periods having lengths different from each other. Any two or three of the first period, the second period, the third period, and the fourth period may be periods having the same length.

The first period and the second period are not limited to periods obtained by multiplying the cycle in which the power value is acquired by the moving average number of times of the power value, and may be periods of any length set by the user. Similarly, the third period and the fourth period are not limited to periods obtained by multiplying the cycle in which the resistance value is acquired by the moving average number of times of the resistance value, and may be periods of any length set by the user.

The power value and the resistance value acquired by the acquisition unit 100 may not be subjected to the low-pass filter processing, or may be subjected to the low-pass filter processing other than moving average.

It may be configured as an abnormality determination system that the first determination unit 110, the second determination unit 120, and the third determination unit 130 are positioned in different apparatuses such as servers. The abnormality determination system includes a first device in which the first determination unit 110 is positioned and a second device in which the second determination unit 120 is positioned, for example. The acquisition unit 100 is provided in each of the first device and the second device, and the first device and the second device are connected to communicate with each other in a wired or wireless manner. The acquisition unit of the first device acquires a determination result of the second determination unit 120. With such a configuration, it is possible to implement the abnormality determination system capable of more accurately determining an abnormality of the heater without using temperature information of the heater while supporting various embodiments.

A threshold used for abnormality determination may be set in accordance with the target temperature of the heater, for example. The first determination unit 110 sets the threshold based on the power value acquired in a settling state in which the abnormality determination can be performed (that is, a state in which it is determined that a settling condition is satisfied) when a temperature of the heater is controlled to the target temperature. With such a configuration, an abnormality of the heater can be determined more accurately.

The threshold is calculated by multiplying the resistance value in the settling state acquired first by a coefficient (for example, 1.1), for example. The "resistance value in the settling state acquired first" is a resistance value of the electric heating element 10 acquired when a brand-new heater that has never been used after manufacturing is in the power settling state and the resistance settling state, for example. The coefficient is set according to a type or use condition of the heater, for example.

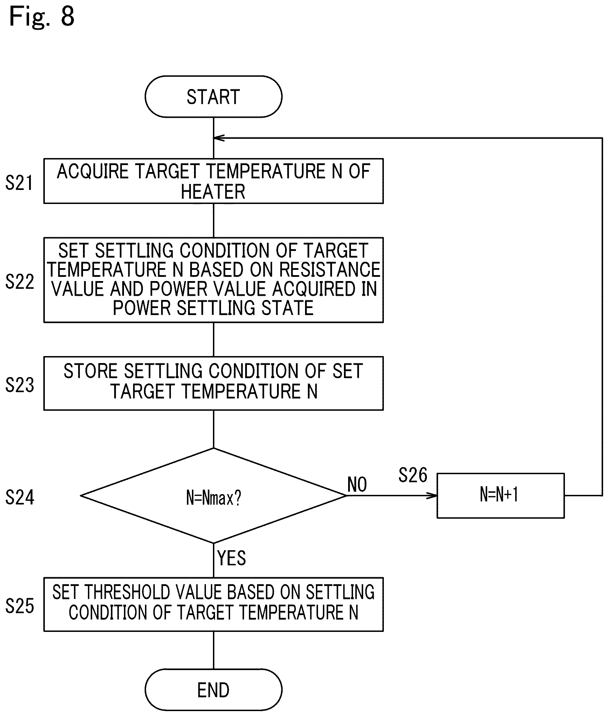

The set threshold is stored in the storage 3 in a state associated with the target temperature of the heater, for example. As shown in Fig. 8, thresholds set one for each of a plurality of mutually different target temperatures may be preset, and may be stored in the storage 3. A threshold setting method shown in Fig. 8 is implemented by the CPU executing a predetermined program, for example.

As shown in Fig. 8, when the threshold setting method is started, the acquisition unit 100 acquires a target temperature N of the heater (step S21). When the target temperature N of the heater is acquired, the abnormality determination device 1 sets a settling condition of the target temperature N based on the resistance value and the power value acquired in the power settling state (step S22). In the abnormality determination device 1, the first target value setting unit 140 sets the first target value as a settling condition of the target temperature N determined that the power settling state is established, and the second target value setting unit 150 sets the second target value as a settling condition of the target temperature N determined that the resistance settling state is established. The settling condition of the set target temperature N is stored in the storage 3 (step S23).

When the settling condition of the target temperature N is stored, the first determination unit 110 determines whether N = N_{MAX} (step S24). When it is determined that N = N_{MAX}, the first determination unit 110 sets a threshold corresponding to the target temperature N based on the settling condition of the target temperature N (step S25), and the threshold setting processing ends. The threshold corresponding to the set target temperature N is stored in the storage 3. When it is not determined that N = N_{MAX}, the first determination unit 110 sets N = N + 1 (step S26), the process returns to step S21, and the acquisition unit 100 acquires a target temperature N+1 of the heater. The target temperature N and the target temperature N+1 are temperatures different from each other, and for example, the target temperature N+1 is higher than the target temperature N.

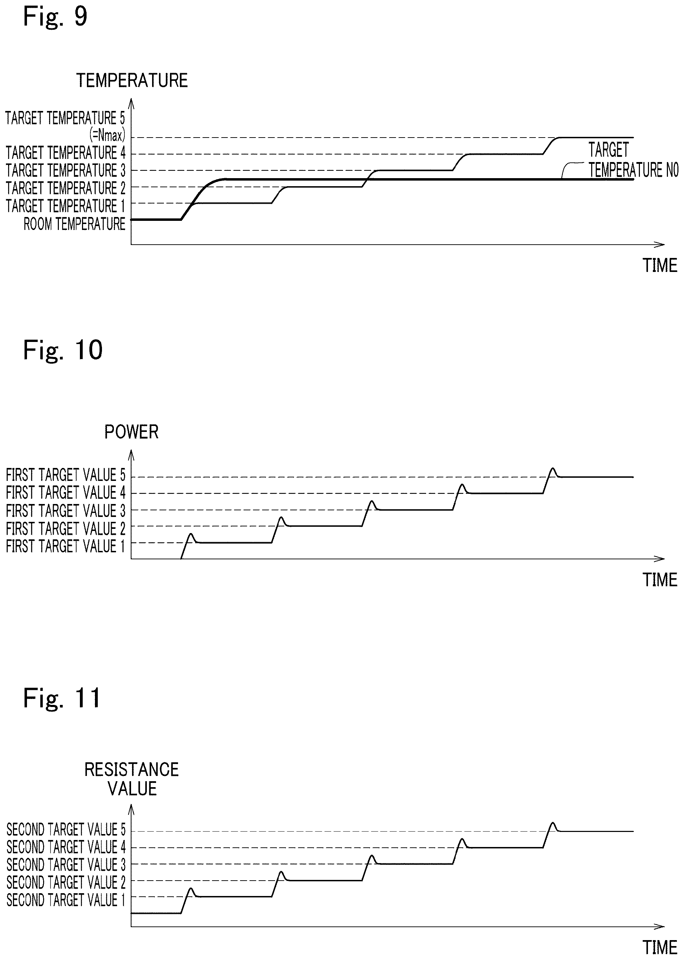

Figs. 9 to 11 show examples of the target temperature, the first target value, and the second target value when the target temperature N is sequentially increased. Here, N_{MAX} = 5, and the first target value and the second target value having the same number at the end as the target temperature constitute the settling condition of the target temperature. For example, a settling condition of a target temperature 1 includes a first target value 1 and a second target value 2.

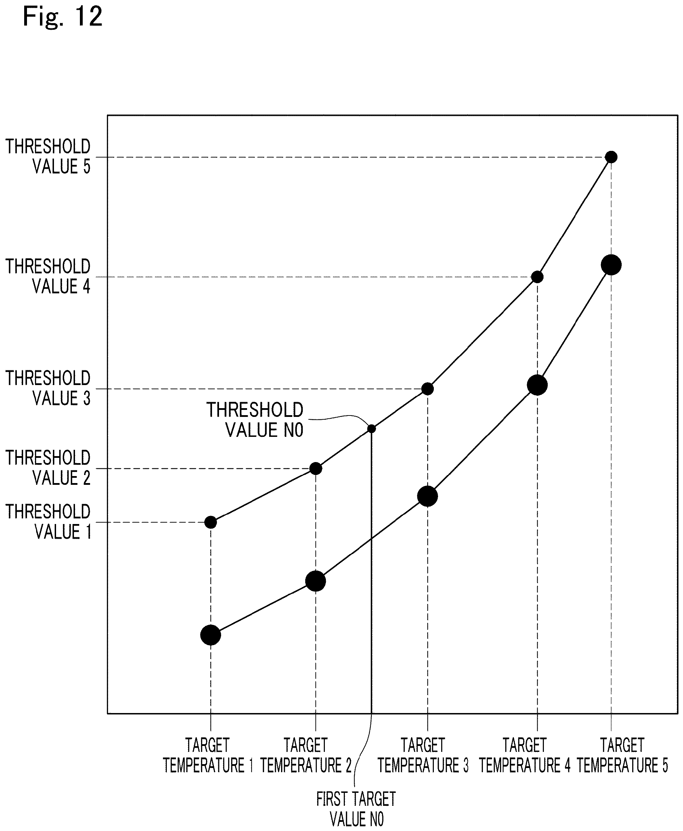

When a threshold corresponding to the target temperature set for the heater is not stored in the storage 3, the threshold not stored in the storage 3 is calculated from a plurality of thresholds stored in the storage 3. For example, it is assumed that the target temperature of the heater is a target temperature N₀ shown in Fig. 9. The target temperature N₀ is a value between target temperatures 2 and 3, and a threshold corresponding to the target temperature N₀ is not stored in the storage 3. In this case, as shown in Fig. 12, the first determination unit 110 calculates the threshold corresponding to the target temperature N₀ not stored in the storage 3 from a plurality of thresholds corresponding to target temperatures 1 to 5 stored in the storage 3. For example, when the target temperature N0 is a median value between the target temperatures 2 and 3, an average of a threshold 2 corresponding to the target temperature 2 and a threshold 3 corresponding to the target temperature 3 is calculated as the threshold N₀. With such a configuration, it is possible to more accurately determine an abnormality of the heater while reducing a storage capacity of the storage 3.

The abnormality determination device 1 may include a processor such as an MPU, a GPU, a DSP, an FPGA, or an ASIC, not limited to the CPU 2. The storage 3 may include an internal recording medium or an external recording medium, for example. The internal recording medium includes a nonvolatile memory and the like. The external recording medium includes a hard disk (HDD), a solid-state drive (SSD), an optical disc device, and the like.

As described above, various embodiments in the present disclosure have been described in detail with reference to the drawings. Lastly, various aspects of the present disclosure will be described. In the following description, as an example, reference numerals are also added.

An abnormality determination device 1 according to a first aspect of the present disclosure includes:
an acquisition unit 100 configured to acquire a resistance value and a power value of an electric heating element 10 of a heater calculated from a voltage across the electric heating element 10 and a current flowing through the electric heating element 10;
a first determination unit 110 configured to perform an abnormality determination that is a determination of whether the heater is abnormal based on the acquired resistance value; and
a second determination unit 120 configured to determine whether the acquired power value is in a power settling state within a width with respect to a first target value,
wherein the first determination unit 110 performs the abnormality determination based on the acquired resistance value when the second determination unit 120 determines that the power settling state is established over a first period.

The abnormality determination device 1 according to a second aspect of the present disclosure, wherein
low-pass filter processing is applied to the resistance value.

The abnormality determination device 1 according to a third aspect of the present disclosure, wherein
low-pass filter processing applied to the power value is moving average.

The abnormality determination device 1 according to a fourth aspect of the present disclosure, wherein
the first period is a period obtained by multiplying a cycle in which the power value is acquired by a moving average number of times of the power value.

The abnormality determination device 1 according to a fifth aspect of the present disclosure, including
a first target value setting unit 140 configured to set the first target value, wherein
the first target value setting unit 140 sets the power value when setting of the first target value is started as a temporary first target value, and sets the temporary first target value as the first target value when it is determined that the power value all acquired within a second period is within a width with respect to the temporary first target value.

The abnormality determination device 1 according to a sixth aspect of the present disclosure, wherein
the first target value setting unit 140 resets the power value acquired last as the temporary first target value when it is determined that the power value all acquired in the second period is not within the width with respect to the temporary first target value.

The abnormality determination device 1 according to a seventh aspect of the present disclosure, wherein
the power value is subjected to moving average, and
the second period is a period obtained by multiplying a cycle in which the power value is acquired by a moving average number of times of the power value.

The abnormality determination device 1 according to an eighth aspect of the present disclosure, including
a third determination unit 130 configured to determine whether the acquired resistance value is in a resistance settling state within a width with respect to a second target value, wherein
the first determination unit 110 performs the abnormality determination when the second determination unit 120 determines that the power settling state is established over the first period and the third determination unit 130 determines that the resistance settling state is established over a third period.

The abnormality determination device 1 according to a ninth aspect of the present disclosure, wherein low-pass filter processing is applied to the resistance value.

The abnormality determination device 1 according to a tenth aspect of the present disclosure, wherein low-pass filter processing applied to the resistance value is moving average.

The abnormality determination device 1 according to an eleventh aspect of the present disclosure, wherein the third period is a period obtained by multiplying a cycle in which the resistance value is acquired by a moving average number of times of the resistance value.

The abnormality determination device 1 according to a twelfth aspect of the present disclosure, including
a second target value setting unit 150 configured to set the second target value, wherein
the second target value setting unit 150 sets as a temporary second target the resistance value when setting of the second target value is started value, and sets the temporary second target value as the second target value when it is determined that the resistance value all acquired within a fourth period is within a width with respect to the temporary second target value.

The abnormality determination device 1 according to a thirteenth aspect of the present disclosure, wherein
the second target value setting unit 150 resets the resistance value acquired last as the temporary second target value when it is determined that the resistance value all acquired within the fourth period is not within the width with respect to the temporary second target value.

The abnormality determination device 1 according to a fourteenth aspect of the present disclosure, wherein
the second target value setting unit 150 resets the second target value based on an average of the resistance value acquired most recent multiple times when the acquired power value is in the power settling state and the acquired resistance value is in the resistance settling state.

The abnormality determination device 1 according to a fifteenth aspect of the present disclosure, wherein
the resistance value is subjected to moving average, and
the fourth period is a period obtained by multiplying a cycle in which the resistance value is acquired by a moving average number of times of the resistance value.

The abnormality determination device 1 according to a sixteenth aspect of the present disclosure, wherein
the first determination unit 110 determines that the heater is abnormal when the acquired resistance value is larger than a threshold set according to a target temperature of the heater.

The abnormality determination device 1 according to a seventeenth aspect of the present disclosure, wherein
the first determination unit 110 sets the threshold based on a settling condition for a determination for the power settling state and a settling condition for a determination for the resistance settling state when a temperature of the heater is controlled to the target temperature.

The abnormality determination device 1 according to an eighteenth aspect of the present disclosure, including
a storage 3 configured to store the threshold set one for each of a plurality of target temperatures different from each other, and
wherein when the threshold corresponding to the target temperature set in the heater is not stored in the storage 3, the first determination unit 110 calculates the threshold not stored in the storage 3 from the plurality of thresholds stored in the storage 3.

An abnormality determination method according to a nineteenth aspect of the present disclosure includes:
acquiring a resistance value and a power value of an electric heating element 10 of a heater calculated from a voltage across the electric heating element 10 and a current flowing through the electric heating element 10;
determining whether the acquired power value is in a power settling state within a width with respect to a first target value; and
performing an abnormality determination that is a determination of whether the heater is abnormal based on the acquired resistance value when it is determined that the power settling state is established over a first period.

An abnormality determination system according to a twentieth aspect of the present disclosure includes:
a first device; and a second device, wherein
the first device includes:
   a first acquisition unit configured to acquire a resistance value and a power value of an electric heating element 10 of a heater calculated from a voltage across the electric heating element 10 and a current flowing through the electric heating element 10, and
   a first determination unit 110 configured to perform an abnormality determination that is a determination of whether the heater is abnormal based on the acquired resistance value; and
the second device includes:
   a second acquisition unit configured to acquire the resistance value and the power value of the electric heating element 10, and
   a second determination unit 120 configured to determine whether the acquired power value is in a power settling state within a width with respect to a first target value,
the second device communicatively connected to the first device,
the first acquisition unit acquires a determination result of the second determination unit 120, and
the first determination unit 110 performs the abnormality determination based on the acquired resistance value when the second determination unit 120 determines that the power settling state is established over a first period.

Appropriately combining any embodiment or modification out of the various embodiments or modifications allows the effect of each thereof to be produced. In addition, a combination of embodiments, a combination of examples, or a combination of an embodiment and an example is possible, and a combination of features of different embodiments or examples is also possible.

The present disclosure is sufficiently described in connection with the preferred embodiments with reference to the accompanying drawings, and various modifications and corrections are apparent for those skilled in the art. It should be understood that as long as such modifications and corrections do not depart from the scope of the present disclosure by the attached claims, they are included therein.

### INDUSTRIAL APPLICABILITY

The abnormality determination device of the present disclosure can be applied not only to an electric heater but also to a heater including an electric heating element that generates heat by resistance heating, such as a fuse, a conducting wire, and a power transmission line.

The abnormality determination method of the present disclosure can be applied not only to an electric heater but also to a heater including an electric heating element that generates heat by resistance heating, such as a fuse, a conducting wire, and a power transmission line.

The abnormality determination system of the present disclosure can be applied not only to an electric heater but also to a heater including an electric heating element that generates heat by resistance heating, such as a fuse, a conducting wire, and a power transmission line.

### EXPLANATION OF REFERENCES

- 1: abnormality determination device
- 2: CPU
- 3: storage
- 4: communication unit
- 10: electric heating element
- 11: temperature controller
- 12: SSR
- 13: power supply
- 20: current sensor
- 30: voltage sensor
- 100: acquisition unit
- 110: first determination unit
- 120: second determination unit
- 130: third determination unit
- 140: first target value setting unit
- 150: second target value setting unit

## Claims

1. An abnormality determination device, comprising:
an acquisition unit configured to acquire a resistance value and a power value of an electric heating element of a heater calculated from a voltage across the electric heating element and a current flowing through the electric heating element;
a first determination unit configured to perform an abnormality determination that is a determination of whether the heater is abnormal based on the acquired resistance value; and
a second determination unit configured to determine whether the acquired power value is in a power settling state where the acquired power value is within a width with respect to a first target value,
wherein the first determination unit performs the abnormality determination based on the acquired resistance value when the second determination unit determines that the power settling state is established over a first period.

2. The abnormality determination device according to claim 1, wherein low-pass filter processing is applied to the resistance value.

3. The abnormality determination device according to claim 2, wherein low-pass filter processing applied to the power value is moving average.

4. The abnormality determination device according to claim 3, wherein
the first period is a period obtained by multiplying a cycle in which the power value is acquired by a moving average number of times of the power value.

5. The abnormality determination device according to any one of claims 1 to 4, comprising
a first target value setting unit configured to set the first target value, wherein the first target value setting unit sets the power value when setting of the first target value is started as a temporary first target value, and sets the temporary first target value as the first target value when it is determined that the power value all acquired within a second period is within a width with respect to the temporary first target value.

6. The abnormality determination device according to claim 5, wherein
the first target value setting unit resets the power value acquired last as the temporary first target value when it is determined that the power value all acquired in the second period is not within the width with respect to the temporary first target value.

7. The abnormality determination device according to claim 5 or 6, wherein
the power value is subjected to moving average, and
the second period is a period obtained by multiplying a cycle in which the power value is acquired by a moving average number of times of the power value.

8. The abnormality determination device according to any one of claims 1 to 7, comprising
a third determination unit configured to determine whether the acquired resistance value is in a resistance settling state where the acquired resistance value is within a width with respect to a second target value, wherein
the first determination unit performs the abnormality determination when the second determination unit determines that the power settling state is established over the first period and the third determination unit determines that the resistance settling state is established over a third period.

9. The abnormality determination device according to claim 8, wherein low-pass filter processing is applied to the resistance value.

10. The abnormality determination device according to claim 9, wherein low-pass filter processing applied to the resistance value is moving average.

11. The abnormality determination device according to claim 10, wherein
the third period is a period obtained by multiplying a cycle in which the resistance value is acquired by a moving average number of times of the resistance value.

12. The abnormality determination device according to any one of claims 8 to 11, comprising
a second target value setting unit configured to set the second target value, wherein
the second target value setting unit sets as a temporary second target value the resistance value when setting of the second target value is started, and sets the temporary second target value as the second target value when it is determined that the resistance value all acquired within a fourth period is within a width with respect to the temporary second target value.

13. The abnormality determination device according to claim 12, wherein
the second target value setting unit resets the resistance value acquired last as the temporary second target value when it is determined that the resistance value all acquired within the fourth period is not within the width with respect to the temporary second target value.

14. The abnormality determination device according to claim 12 or 13, wherein
the second target value setting unit resets the second target value based on an average of resistance values acquired most recent multiple times when the acquired power value is in the power settling state and the acquired resistance value is in the resistance settling state.

15. The abnormality determination device according to any one of claims 12 to 14, wherein
the resistance value is subjected to moving average, and
wherein the fourth period is a period obtained by multiplying a cycle in which the resistance value is acquired by a moving average number of times of the resistance value.

16. The abnormality determination device according to any one of claims 8 to 15, wherein
the first determination unit determines that the heater is abnormal when the acquired resistance value is larger than a threshold set according to a target temperature of the heater.

17. The abnormality determination device according to claim 16, wherein
the first determination unit sets the threshold based on a settling condition for a determination for the power settling state and a settling condition for a determination for the resistance settling state when a temperature of the heater is controlled to the target temperature.

18. The abnormality determination device according to claim 16 or 17, comprising
a storage configured to store the threshold set one for each of a plurality of target temperatures different from each other, wherein
when the threshold corresponding to the target temperature set in the heater is not stored in the storage 3, the first determination unit calculates the threshold not stored in the storage from the plurality of thresholds stored in the storage.

19. An abnormality determination method, comprising:
acquiring a resistance value and a power value of an electric heating element of a heater calculated from a voltage across the electric heating element and a current flowing through the electric heating element;
determining whether the acquired power value is in a power settling state within a width with respect to a first target value; and
performing an abnormality determination that is a determination of whether the heater is abnormal based on the acquired resistance value when it is determined that the power settling state is established over a first period.

20. An abnormality determination system, comprising:
a first device; and a second device, wherein
the first device includes:
a first acquisition unit configured to acquire a resistance value and a power value of an electric heating element of a heater calculated from a voltage across the electric heating element and a current flowing through the electric heating element, and
a first determination unit configured to perform an abnormality determination that is a determination of whether the heater is abnormal based on the acquired resistance value; and
the second device includes:
a second acquisition unit configured to acquire the resistance value and the power value of the electric heating element 10, and
a second determination unit configured to determine whether the acquired power value is in a power settling state within a width with respect to a first target value,
the second device communicatively connected to the first device,
the first acquisition unit acquires a determination result of the second determination unit, and
the first determination unit performs the abnormality determination based on the acquired resistance value when the second determination unit determines that the power settling state is established over a first period.
